# EUROPEAN PATENT SPECIFICATION

(11) **EP 1 659 638 B1**
(45) Date of publication and mention of the grant of the patent: **12.01.2011**
(21) Application number: 05025288.1
(22) Date of filing: 18.11.2005
(51) Int. Cl.: H01L 29/78, H01L 29/423, H01L 21/336, H01L 29/49, H01L 21/28

(54) **Power MOS device and corresponding manufacturing method**
MOS-Leistungsanordnung und entsprechendes Herstellungsverfahren
Dispositif MOS de puissance et méthode de fabrication correspondante

(30) Priority: 19.11.2004 IT MI20042244
(43) Date of publication of application: 24.05.2006
(73) Proprietor: STMicroelectronics Srl, 20041 Agrate Brianza (MB) (IT)
(72) Inventor: Magri', Angelo, 95032 Belpasso (Catania) (IT); Frisina, Ferruccio, 95030 Sant'Agata li Battiati (Catania) (IT); Ferla, Giuseppe, 95021 Acicastello (Catania) (IT)
(74) Representative: Ferrari, Barbara

(56) References cited:
- WO-A-99/33119
- US-A- 5 510 281
- US-A1- 2002 140 042
- PATENT ABSTRACTS OF JAPAN vol. 1997, no. 07, 31 July 1997 (1997-07-31) -& JP 09 082965 A (YOKOGAWA ELECTRIC CORP), 28 March 1997 (1997-03-28)

## Description

### Field of application

The present invention relates to a power MOS device, of the type comprising a very high integration of elementary MOS transistors and used in multiple applications both at low and high supply voltage.

The invention also relates to a method for realising the power MOS device.

### Prior art

As it is well known, in power electronic devices, in particular in power devices of the MOS type, it is important to have the possibility of operating at higher and higher frequencies maintaining the component reliability high.

The nowadays uses of MOS devices in fact require the possibility of operating, both at low supply voltage (20-100V) and at high supply voltage(200-1000V), but, however, at higher and higher frequencies next to the megahertz (MHz).

Power devices are thus subjected to very high voltage and current gradients during the transients and/or during the switches which make the stresses to the device weakening the same burdensome and reduce its activity period in a drastic way.

As it is well known some power MOS devices are realised by thousands or millions of elementary MOS transistors placed in parallel and individually contributing to the overall capacity in current of the device.

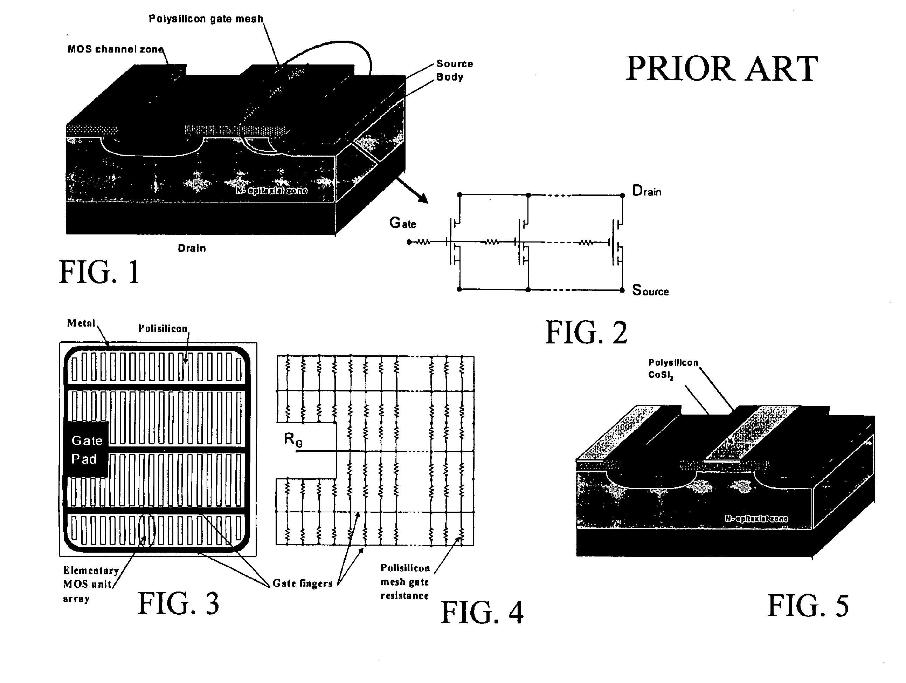

Typically, elementary MOS transistors, as highlighted in figure 1, are realised on semiconductor with polygonal cells or strips and they comprise a body region, which, in the case shown, is of the p type, formed on a suitable substrate, of the n type, and with a source region realised on top.

The body region, together with the source region, forms a channel region covered by an insulating layer, for example a silicon oxide, and by a conductive layer, for example suitably doped polysilicon.

These two insulating and conductive layers represent, for each elementary MOS transistor, the gate dielectric and for the power MOS device they form a biasing mesh also called gate mesh.

The gate mesh is connected to a terminal called gate pad and it allows to distribute the signals inside the MOS device as well as to turn on and/or off all the elementary MOS transistors composing the power MOS device.

A DMOS transistor device described in the US patent No. US 5,510,281 issued on April 23, 1996 to Ghezzo et al. (General Electric Company) comprises gate structures having a gate oxide with a thick central part in direct contact with lateral portions of reduced thickness

An other solution of power semiconductor device comprising such a gate oxide is disclosed in the international application No. WO 99/33119A.

The gate mesh, due to the high polysilicon resistivity (> 10 Ohm/_{[square]}), exhibits resistive contributions along the path which depend on the relative position with respect to the gate pad, as highlighted in the circuit of figure 2, this implies that gate resistance value of each elementary transistor also depends on the distance from the gate pad.

Thus, each elementary MOS transistor, at each switch of the MOS device, responds with a time constant which, being, as known, a function of the input capacity and of the gate resistance, will be distinct for each MOS transistor.

The patent abstract of Japan No. JP 09082965 in the name of Yokogawa Electric Corp. describes a semiconductor device having gate electrodes being conductive spacers adjoining side walls of field oxide films.

The gate resistance is thus an important value because, together with the input capacity of the MOS device, it forms an RC circuit whose time constant is one of the most important parameters influencing the switch speed of power electronic MOS devices. These latter, having to operate at higher and higher frequencies, thus require a more and more reduced time constant, thus trying to reduce the gate resistance, making it homogeneous for the entire MOS device so as to ensure a greater reliability in high frequency applications.

To try and solve such problem a known technique is that of carrying out a suitable metallisation of the gate, process consisting in creating connection buses also called gate fingers, realised in metallic material, so as to connect the gate pad to various points of the gate mesh by "short-circuiting" them, as shown in figure 3 and in the corresponding circuit of figure 4.

A technique is that of increasing the number of gate fingers so as to intersect the gate mesh in the greatest number of points as possible.

Although advantageous under several aspects, such solution exhibits different drawbacks, the main one is that the presence of the gate fingers realised in metallic material reduces the active area of the power MOS device since below the gate fingers it is not possible to integrate the elementary MOS transistors.

Moreover, a further drawback linked to the presence of the gate fingers is due to the fact that they limit the number and the position of the wires connecting to the source pad thus affecting negatively the output resistance of the power MOS device.

A further known solution to reduce the gate resistance provides the decrease of the gate mesh resistance by integrating there inside a very conductive layer. Such process makes use of metallic silicides, such as for example cobalt silicide (CoSi₂), platinum silicide (PtSi), titanium silicide (TiSi₂) or tungsten silicide (WSi₂), which exhibit a layer resistivity of about a lower magnitude order with respect to that of the polysilicon.

For power electronic MOS devices used in faster and faster applications with low gate resistance, problems however emerge linked to the great voltage and current gradients during the transients.

All the solution proposed to reduce the gate resistance exhibit the drawback that two elementary MOS transistors placed at different distance from the gate pad are "unbalanced" with respect to each other in the sense that they exhibit two different gate resistance values and thus two different switch speeds. This effect is more and more evident as faster and faster devices are realised.

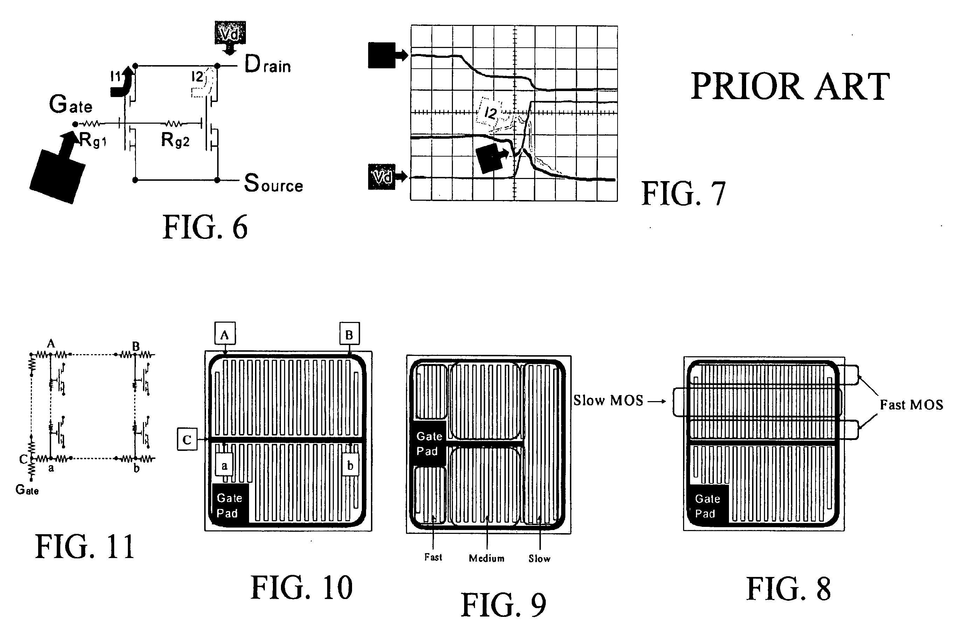

Figure 6 highlights a pattern in parallel of different elementary MOS transistors which exhibit different gate resistances according to the position wherein they are with respect to the gate pad and to the gate fingers.

The diagram reported in figure 7 shows how between elementary MOS transistors wherein there exists an unbalance in the resistance value, during the switch step of the MOS device, different wave forms are produced which distribute the current at stake in a non uniform way. In particular it can be verified how, the current intensity, I2, crossing the slowest component undergoes sudden increases affecting the uniformity of the overall time constant of the electronic MOS device.

Such behaviour in the power MOS device is exponentially increased for the plurality of elementary MOS transistors, this however jeopardises both the correct functionality and the operating duration of the MOS device itself.

For the manufacturing process used in the realisation of a power electronic MOS device it is inevitable that there are unbalances in the current progress. In fact it is good to remember that the distance between one gate finger and the other is around values of 200-2000 µm and in such space a lot of elementary MOS transistors are comprised whose gate biasing occurs by means of the gate mesh. In such case the elementary MOS transistors being closer to the gate fingers will be the fastest while the others will be slower and slower, as highlighted in figure 8.

Further unbalances are due to the fact that for problems due to the assembling step it is complex to realise continuous and equidistant gate fingers (fig. 9). Thus, the power MOS device obtained will exhibit areas with different distances between the gate fingers, as shown in the example of figure 9, and this implies the presence of a gate resistance influenced by the area with lower distance between the gate fingers, since in the calculation of the parallel the areas with higher resistance will have less weight.

Moreover it is good to reveal that although the resistivity of the material used for realising the gate fingers is low, it is possible that their length is such as to introduce resistive contributions which can be compared with the total gate resistance of the power electronic MOS device especially if, for lowering the metallisation mesh resistance, metallic silicides are used.

As highlighted in the example of figure 10 and in the associated circuit of figure 11, the areas in correspondence with the points A and B although being near the gate finger exhibit a different resistance in series due to the contribution of the gate finger section AB, which could have an even higher weight than one Ohm, with a consequent unbalance between the different areas of the power MOS device.

All these causes lead to have power electronic MOS devices weakened by the presence of areas having different gate resistance with consequent negative effects on the switches and during the extreme dynamic stresses with high values of dV/dt and/or dI/dt.

The unbalance can also cause current focalisations which can cause the non correct operation and/or the breaking of the power MOS device.

It is also known how in power electronic MOS devices, especially with low voltage driving, for example those driven by means of driver with output voltage 1.8-2.5 Volt, exhibit a more and more reduced thickness of the gate oxide, typically silicon oxide. This reduction allows to obtain threshold voltage values lower that the Volt without deteriorating the breakdown characteristics of the power electronic MOS device.

However, the reduction of the gate oxide thickness, together with the highest integration density, implies less and less deep junctions and shorter and shorter circuit lengths, with consequent increase of the capacity of the elementary MOS transistors and of the total capacity and with a slowdown of the response speed during the switches.

To try to reduce the capacity using gate oxides other than silicon dioxide is known for example using hafnium oxide, aluminium oxide, silicon oxide / silicon nitride multilayers and others.

Changes in the typology of material used however imply drawbacks mainly linked to the necessary tests which require excessively long and prohibitive times for the current market of power electronic MOS devices.

A further known technique to reduce the total capacity of the device is that of varying the geometry of the gate oxide; such solution provides the realisation of the gate oxide with two different thicknesses in active area as shown for power VDMOS devices, both with channel n and with channel p, in the US patents n° 6,222,232 and n° 6,326,271 to the same Applicant.

In such proposed solutions the gate dielectric exhibits two thicknesses: a thin one realised above the channel region, which allows a low threshold voltage driving, and a thicker one extended to the sole region of the gate/drain capacitor, which allows to significantly reduce the transient capacity of the device and thus also the input capacity.

The definition procedure of the gate structure in the VDMOS devices, according to the prior art, mainly requires a thermal growth of a thick silicon oxide film from the underlying substrate, its photolithographic definition in active area regions and a growth of a thin gate oxide film which will surmount the channel.

Such known technique provides the use of a photolithographic step to define the part of the thick gate electrode in the elementary MOS transistor and it provides a successive and more important photolitographic step to delineate the geometry of the gate electrode.

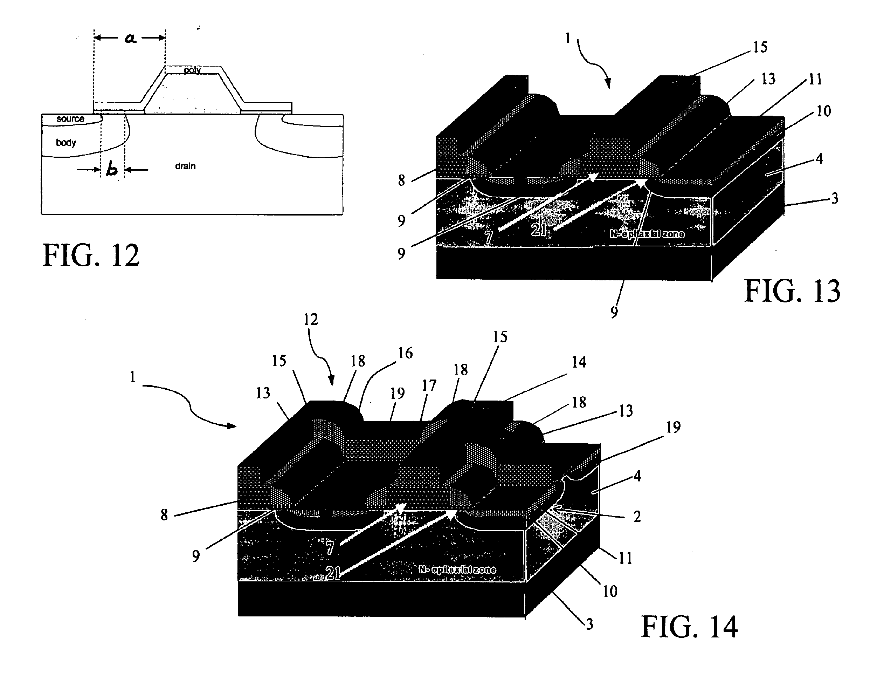

Considering that in the elementary MOS transistor there is the need of having a symmetrical and uniform diffused channel using a known procedure for realising power MOS devices with double oxide thickness imposes a margin, with quite high value, between the delimitation of the gate electrode and the edge of the central thick oxide region, as it can be seen in figure 12.

Such margin labelled with « a » in figure 12 must be sufficiently wide as to ensure that possible misalignments in the photolitographic definition of the gate electrode do not cause the extension of the channel labelled with « b » in figure 12 below the thick oxide region in an asymmetrical way, on the other hand.

Obviously, the need of safeguarding the alignment of the planar structures in active area goes against the need of a greater and greater integration of power MOS transistors and thus against the need of operating with more and more reduced dimensions.

There exist realisations, obtained by using solutions as highlighted for example in the US patent application No. 2002/0140042A1 to the same Applicant, which allow to obtain high integration density devices with self-aligned gate oxide regions. Such realisations, although advantageous under several aspects, exhibit the drawback of significantly reducing the gate mesh in thickness and width and thus they remarkably increase the gate resistance. Moreover, in such known realisations the problems for introducing a silicide layer inside the gate mesh have significantly increased.

The technical problem underlying the present invention is that of devising a power electronic MOS device with a high integration density, thus comprising a plurality of elementary MOS transistors with such a gate structure as to ensure a simultaneous switch and with the same time constant, exhibiting such structural and functional characteristics as to overcome the drawbacks cited with reference to the prior art.

### Summary of the invention

The solution idea underlying the present invention is that of realising a power MOS device, comprising a plurality of elementary MOS transistors, exhibiting an oxide region with double thickness, comprising a conductive structure having conductive portions overlapped onto a part of oxide with greater thickness and further conductive portions defining gate electrodes of the elementary MOS transistors overlapped onto a part of oxide with smaller thickness and being interconnected to the conductive portions of the conductive structure by means of suitable conductive bridges.

On the basis of such solution idea the technical problem is solved by a power MOS device according to claim 1.

The technical problem is also solved by a method for realising a power MOS device according to independent claim 14. Specific embodiments are disclosed in the dependent claims.

The characteristics and the advantages of the power MOS device and of the method according to the invention will be apparent from the following description of embodiments thereof given by way of indicative and non limiting example making reference to the annexed drawings.

### Brief description of the drawings

figures 1 to 4 schematically show two embodiments of a power MOS device according to the prior art with the corresponding equivalent circuit;
figure 5 shows a further embodiment of a power MOS device according to the prior art;
figures 6 and 7 show an electric circuit and a diagram reporting the wave forms in voltage and current of a turn off of two elementary MOS transistors of a power MOS device realised according to the prior art;
figures 8 to 10 schematically show the layout of three different embodiments of a MOS device according to the prior art;
figure 11 shows an equivalent electric circuit of the device of figure 10;
figure 12 shows a section of an embodiment of a structure with a gate oxide having double thickness according to the prior art;
figures 13 and 14 show portions of a power MOS device realised according to the present invention respectively in an intermediate process step and once the device is completed;
figures 15 and 16 show a circuit scheme respectively of a MOS device realised according to the prior art and according to the present invention;
figures 17 and 18 show two diagrams wherein the resistance as seen from an elementary MOS is represented as function of the distance from a gate finger in a comparison between device realised according to the prior art and according to the present invention;
figures 19a and 19b show a partial view of two embodiment versions of a MOS device according to the present invention;
figures 20a to 20h show some steps of the realisation process of a power MOS device according to the present invention;
figure 21 shows a portion of a power MOS device realised according to a further embodiment of the present invention;
figures 22 and 23 show portions of a power MOS device realised according to the present invention respectively at an intermediate and final completion step.

### Detailed description

With reference to such figures, and in particular to the example of figure 14, 1 globally and schematically indicates a power MOS device realised according to the present invention.

The device 1 comprises a plurality of elementary MOS transistors 2 realised on a silicon plate comprising a semiconductor layer 4 overlapped onto a substrate 3. The layer 4 exhibits a first type of conductivity which, in the case highlighted in the figure, is of the N-type while the substrate 3 is of the N+ type.

The elementary MOS transistors 2 exhibit a body region 10, realised in a second type of conductivity, and a source area 11 contained on top.

The elementary MOS transistors 2 exhibit gate structures 12 comprising a gate oxide 7 comprising a thick central part 8 and lateral portions 9 with reduced thickness, as better highlighted in figure 13.

Naturally, the profile of the gate oxide 7 and in particular of the central part 8 can be various and, in the case shown, it exhibits a squared shape substantially upturned T-like.

The gate structures 12 comprise first gate conductive portions 13 overlapped onto the lateral portions 9 of the gate oxide 7 to define gate electrodes for the elementary MOS transistors 2.

The first conductive portions 13, realised in material such as for example polysilicon, flank the central part 8 of the gate oxide 7 and they exhibit, in the example of the figures, a substantially rounded profile. Naturally they can exhibit any other profile. These first gate conductive portions 13 can also be realised with a double layer made of polysilicon and of a metallic silcide.

Moreover, advantageously, the gate structures 12, as highlighted in figure 14, comprise a conductive structure 14, e.g. a mesh, suitable to distribute the signal coming from a gate pad or from a finger, suitably defined on the upper surface of the silicon plate and not highlighted in the figures.

The conductive structure 14 advantageously comprises second conductive portions 15 overlapped onto the thick central part 8 of the gate oxide 7 and suitably contained therein, interconnected to each other and to the first conductive portions 13 by a plurality of conductive bridges 16.

The second conductive portions 15 and the conductive bridges 16 are realised in material such as for example polysilicon and they can be suitably doped.

Advantageously, the second conductive portions 15 being placed above the central thick part 8 can be made very conductive further to hyper-doping.

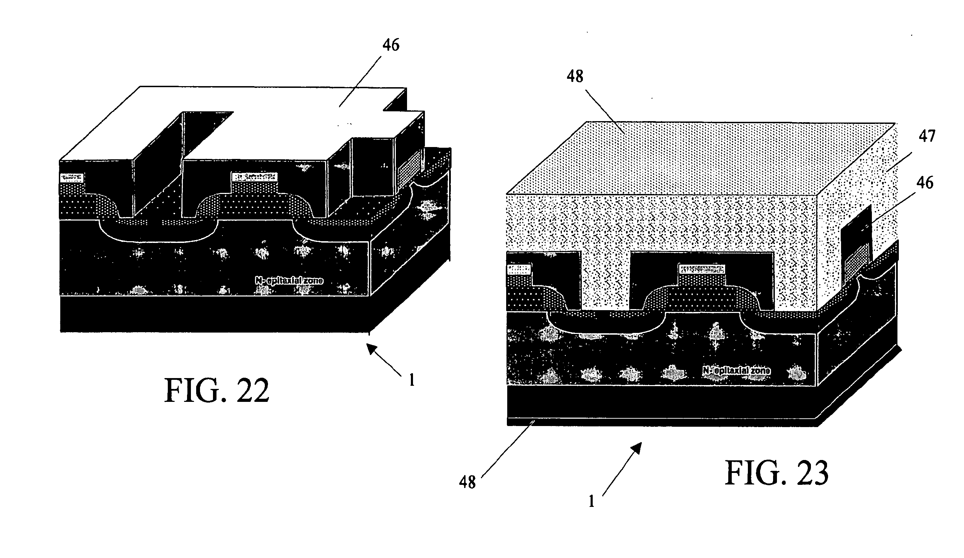

In particular, these second conductive portions 15 can be realised in polysilicon suitably doped for being then, by means of suitable process, transformed, for the whole thickness or only for part thereof, into a metallic silicide 50 as highlighted in the embodiments reported in figures 22 and 23.

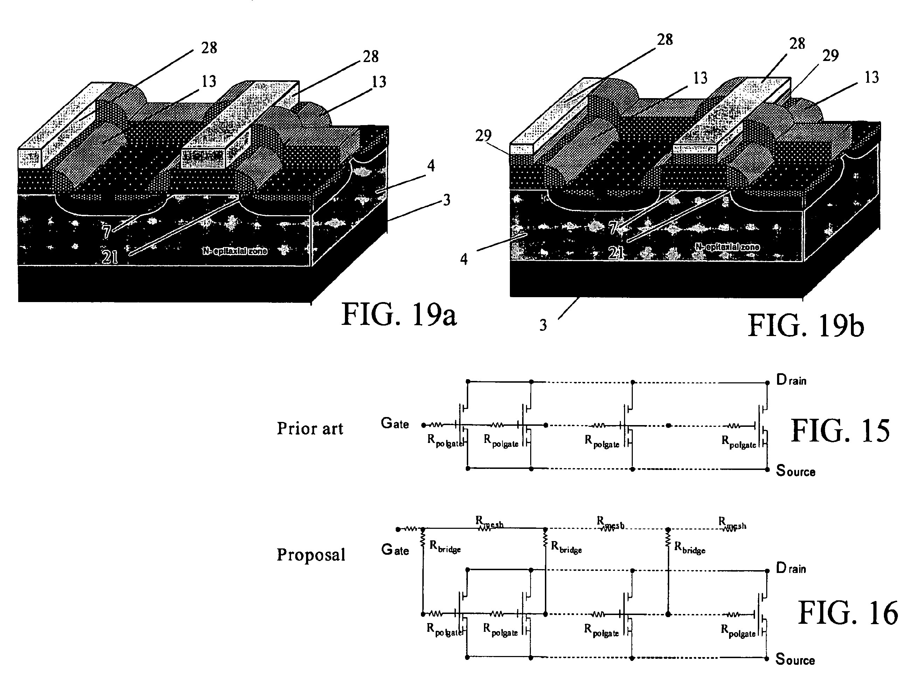

Suitably, the second conductive portions 15 can be realised, entirely as highlighted in figure 19a, in a metallic layer 28 or, as highlighted in figure 19b, they can be realised in a metallic layer 28 overlapped onto a polysilicon layer 29. These realisations allow to improve the conductivity of the conductive structure 14, without jeopardising the functionality of the gate electrode or first conductive portions 13 being separated therefrom although connected by means of the conductive bridges 16.

In fact, the conductive bridges 16 are transversally arranged between second consecutive conductive portions 15 and they comprise a flat portion 17, overlapped onto the semiconductor layer 4, and curved ends 18 arranged above the first conductive portions 13, thus allowing to connect them electrically.

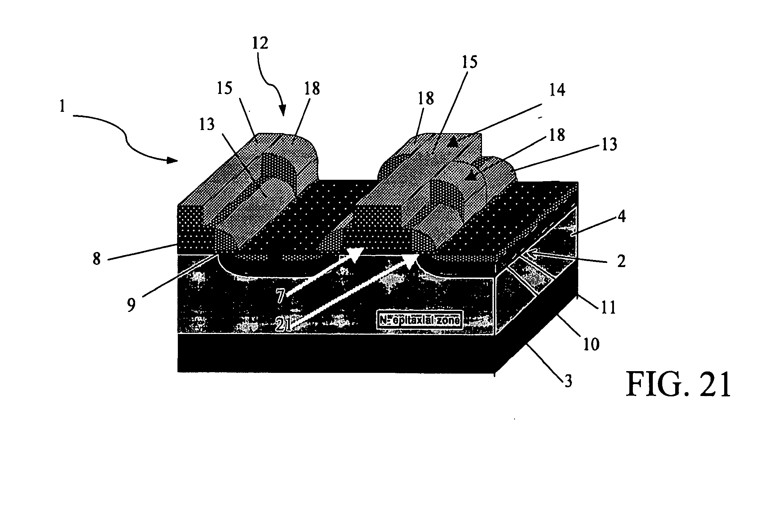

Advantageously, the flat portion 17 of each conductive bridge 16, can be partially interrupted or completely eliminated for reducing the capacities associated therewith as highlighted in figure 21.

The conductive bridges 16 further allow to electrically connect the second conductive portions 15 to the first underlying conductive portions 13 allowing an optimal distribution of the signal coming from the gate pad or from a gate finger to the elementary MOS transistors 2.

Naturally, the number and the mutual distance of the conductive bridges 16 allow to influence the speed of the power MOS device 1 and the propagation modes of the signal coming from the gate pad are thus suitably programmed and defined according to the needs.

Between the flat portion 17 of the conductive bridges 16 and the underlying semiconductor layer 4 there is an insulating interconnection portion 19, realised in material such as for example oxide, which allows to avoid the electric contact between the two parts.

Advantageously, one part or the entire insulating interconnection portion 19 can be realised simultaneously with the central part 8 of the gate oxide 7, thus exhibiting such a thickness as to allow an incredible gain on the capacities associated therewith.

Suitably, the body regions 10 of the elementary MOS transistors 2 are realised between two consecutive conductive bridges 16, they are insulated from each other and they exhibit a peripheral diffusion below the lateral portions 9 of the gate oxides 7 and below the consecutive conductive bridges 16 to define channel regions 21.

The power MOS device 1 realised according to the present invention thus exhibits a gate structure 12 allowing to separate the transmission line of the signal in the power MOS device 1 by realising the conductive structure 14 from the gate electrodes by realising first conductive portions 13.

Moreover, the use of a gate oxide 7 with double thickness allows to improve the dynamic operation of the power MOS device.

More in particular, the dynamic response of the MOS device 1 is improved and balanced, in fact, considering an electric circuit relative to the elementary MOS transistors 2 according to the present invention and reported in figure 16, it is evident how each elementary MOS transistor 2 is connected to the gate pad or to a gate finger by means of the conductive structure 14 e.g. being a mesh, which is represented by a resistance given by the series of the resistances Rmesh and Rbridge and which is placed in parallel with the resistance of the first conductive portion 13, or gate electrode, indicated as Rpolgate.

Moreover, being the conductive structure 14 arranged above the thick central part 8 of the gate oxide 7, this allows that the resistance series Rₘₑₛₕ and R_{bridge} is always much smaller than the resistance of the gate electrode R_{polgate}, thus having a lower weight.

In such way the elementary MOS transistors 2 placed farther from the gate pad or from the gate finger will be made faster with respect to the a configuration according to the prior art wherein the conductive structure is also the gate electrode of the elementary MOS transistors 2 (R_{polgate}) as highlighted in figure 15. Vice versa, those placed closer to the gate pad or to the finger will be slowed down and this allows to uniform the time constant of the plurality of elementary MOS transistors 2 balancing the dynamic response of the power MOS device 1.

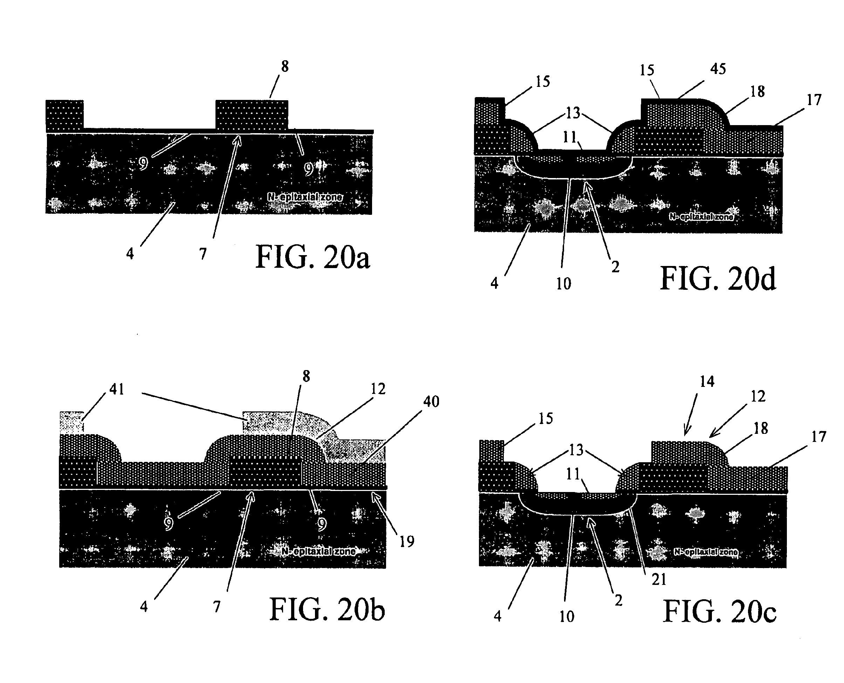

The invention also relates to a method for realising a power MOS device shown making reference to figures 20a to 20h.

The realisation steps and the structures described hereafter do not form a complete process flow for the realisation of power MOS devices. In fact the present invention can be put into practice together with the realisation techniques of the MOS devices currently used in the field and hereafter only those steps necessary for the comprehension of the invention are described.

The power MOS device realised is that shown in figures 22 and 23 and it is of the type comprising a plurality of elementary power MOS transistors 2.

Hereafter the same above-indicated reference numbers will be used for identifying corresponding parts.

The realisation method according to the invention includes the following steps:
- making a thick oxide layer with thickness values comprised between 300-1300 nm (3000-13000 A) grow, according to the prior art, from a semiconductor layer 4 of a silicon plate;
- providing a photomasking by means of the placement of a resist 41 on the thick oxide for defining a plurality of gate oxides 7, according to the prior art;
- anisotropically etching the thick oxide layer to realise a plurality of central parts 8 with high thickness;

- removing the resist;
- realising an oxide layer with reduced thickness, comprised between 15-150 nm (150-1500 A) to form lateral portions 9 of the central parts 8 of the gate oxides 7 and to form a plurality of interconnection portions 19 transversally connecting the lateral portions 9.

Advantageously, the walls of the central part 8 of the gate oxide 7 can be very vertical to allow the formation of suitable polysilicon spacers.

Possibly, the interconnection portions 19 can be obtained simultaneously with the central parts 8 by means of the anisotropic etching to the thick oxide layer.
The method further provides the stepsof: depositing, above the layer 4, a conductive layer 40 with thickness of about 200-800 nm (2000-8000 A) as highlighted in figure 20b. The conductive layer 40, realised for example in polysilicon, if necessary for the application, can be suitably doped;
providing a photo-masking of the conductive layer 40, by placing a resist 41, to defined a conductive structure 14 of a gate structure 12 suitable to distribute a signal coming from a gate pad or from a finger, suitably defined on the upper surface of the silicon plate and not highlighted in the figures;
anisotropically etching the conductive layer 40 to realise first conductive portions 13, of the gate structure 12, overlapped onto the lateral portions 9 of the gate oxide 7, as highlighted in figure 20c.

The conductive structure 14 is of the type comprising a plurality of second conductive portions 15 overlapped onto the central part 8 of the gate oxide 7, and a plurality of conductive bridges 16 overlapped onto the interconnection portions 19.

Moreover, an anisotropic etching typology will be suitably used allowing to leave a residue, also called spacer, along the walls of the etched material. This allows to realise said first conductive portions 13 or gate electrodes of the elementary MOS transistors 2 self-aligned.

The method then includes the step of:
removing the resist.
   According to the present invention the gate structure 12 comprises a plurality of first conductive portions 13 overlapped onto the lateral portions 9 of the gate oxide 7 and a conductive structure 14 which comprises a plurality of second conductive portions 15 overlapped onto the central thick part 8 of the gate oxide 7 and interconnected to each other and to the first conductive portions 13 by a plurality of conductive bridges 16 overlapped onto the interconnection portions 19.

Suitably, the conductive bridges 16 exhibit a flat portion 17, arranged transversally between consecutive first conductive portions 13 and two curved ends 18 which are placed above and transversally to said first conductive portions 13 to reach corresponding second conductive portions 15. The conductive bridges 16 thus allowing to electrically connect consecutive second conductive portions 15 to each other and to connect them to corresponding first portions 13.

The method further includes the step of:
forming a plurality of body wells to realise body regions 10 and source wells to realise source areas 11 according to the prior art, as highlighted in figure 20c.

In particular the body regions 10, arranged between two consecutive conductive bridges 16 are insulated from each other and exhibit a peripheral diffusion below said lateral portions 9 of the gate oxide 7 and below the consecutive conductive bridges 16 to define channel regions 21.

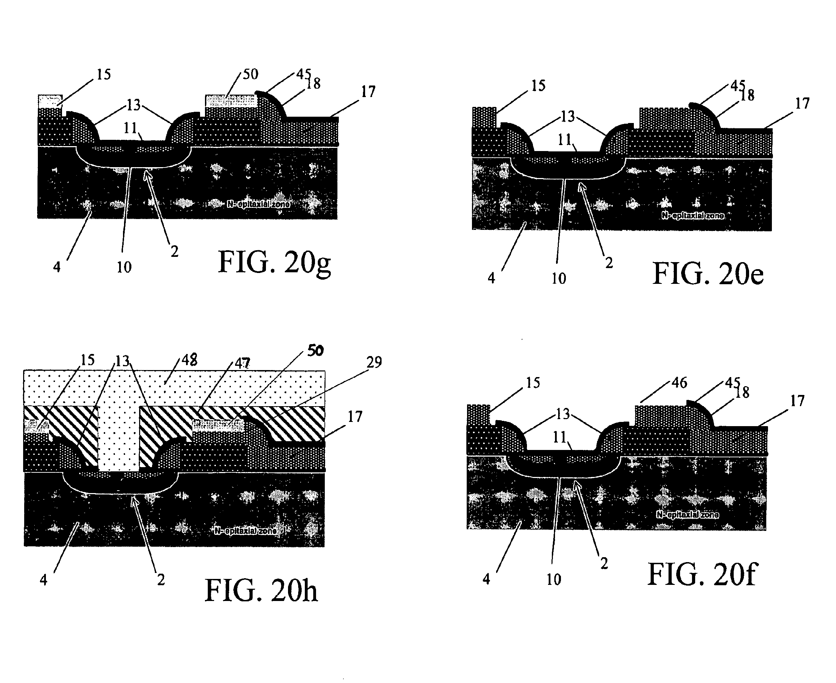

Possibly the method then includes the steps of:
depositing, above the layer 4, an insulating layer 45 of suitable thickness of about 10-500 nm (100-5000 A), as shown in figure 20d;
providing a photo-masking of the insulating layer 45 placed above the gate structure 12 except for the upper part of the second conductive portions 15, to thus define suitable areas to be silicidised as highlighted in figure 20e;
depositing, above the second conductive portions 15, a suitable metallic layer 46 of thickness equal to approximately 20-500 nm (200-5000 A), as shown in figure 20f;
carrying out a thermal process or other process suitable to make the metallic layer 46 react with an upper portion of the second conductive portions 15, realised in silicon, which, reacting, define a silicidised layer 50;
etching the metallic layer 46 by taking away the part which has not reacted, as highlighted in figure 20g.

The method includes the following completion step:
H covering the structure with a suitable intermediate dielectric layer 47 and forming metallisations 48 on the front and on the rest according to the prior art, suitable to obtain a device as shown in figures 20h, 22 and 23.

The method described according to the present invention allows to realise a power MOS device comprising a gate structure allowing to separate the gate electrode of the elementary MOS transistors 2 from the distribution mesh of the signal coming from the gate pad, such arrangement obtained by means of a synergy between the layout of the device and a process sequence.

The method realised is applied to any power MOS device having a double gate oxide thickness on whose thick part a conductive structure is realised and by a conductive gate separated from said conductive structure and placed on the thin part of the gate oxide and being placed in electric connection with the conductive structure by means of suitable conductive bridges.

Main advantage of the power MOS device obtained according to the present invention is that the gate structure allows, on one side, to separate the signal transmission mesh coming from the gate pad from the gate electrode of each elementary MOS transistor and, on the other, it allows, by using a gate oxide with double level, to harmonise the response during the dynamic step of the power MOS device.

Moreover, a further advantage of the present invention is that the conductive structure is completely self-aligned to the gate electrode of each elementary MOS transistor being obtained through deposition and etching steps. It is thus simpler to be realised and more precise without the use of alignment between masks.

A further advantage of a MOS device realised by means of the present invention is the possibility of having a greater flexibility in the control of the gate resistance in relation to the number of the conductive bridges realised and to their mutual distance. In such way, by means of a suitable layout, it is possible to vary the switch speed of the power MOS device as well as the propagation mode of the driving signal according to the needs.

In particular, the present invention allows to distribute the conduction bridges so that each area comprised between two consecutive bridges has the same highest gate resistance value R_{polgate} and a minimal gate resistance value linearly depending on the distance from the gate pad or, if present, on the gate fingers or fingers.

A further advantage linked to the separation between the conductive structure or mesh and the gate electrode of the elementary MOS transistors is that in such way the conductive material placed on the central part of the gate oxide can be transformed into a silicide avoiding all the problems linked to the faultiness or mechanical stress of the gate electrode which remains in conductive material such as polysilicon.

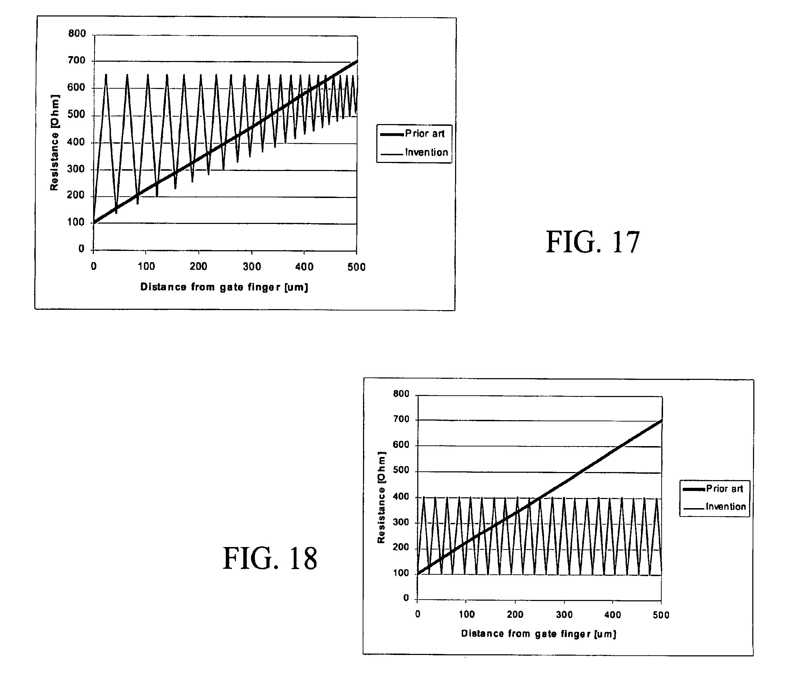

From experimental tests it has been possible to verify that the power MOS device realised by means of the present invention is particularly satisfying if the resistance gate seen from the elementary MOS transistors is analysed with respect to all the other techniques currently used in the field. In particular, as it can be seen from the diagram of figure 17, there is a more harmonious progress of the resistance value allowing to balance the response of the device during the dynamic step more.

If the conductive structure is added or substituted with a metal this implies enormous advantages on the gate resistance values as highlighted in the diagram of figure 18 which allows to considerably increase the switch speed of the MOS device as well as the harmonisation of the response during the dynamic step.

The MOS device realised by means of the present invention employs a gate oxide with double thickness in technology VLSI keeping the compatibility with a partial or total silicidising process of the polysilicon.

## Claims

1. Power MOS device of the type
comprising a plurality of elementary power MOS transistors (2) having respective gate structures (12) on a semiconductor layer (4), each gate structure comprising a gate oxide (7) having a thick central part (8) in direct contact with lateral portions (9) of reduced thickness;
said gate structures (12) comprising:
- first conductive portions (13) overlapped onto said lateral portions (9) of gate oxide (7), said first conductive portions (13) defining for each of said elementary MOS transistors (2) a gate electrode,
- a conductive structure (14) connected to a gate pad or a gate finger of said MOS device (1) in order to distribute a signal coming from said gate pad or gate finger, said conductive structure (14) comprising a plurality of second conductive portions (15) overlapped onto the thick central part (8) of gate oxide (7) of each elementary MOS transistor (2);
said conductive structure (14) further comprising a plurality of conductive bridges (16) that interconnect to each other said second conductive portions (15) and said second conductive portions (15) to ssaid first conductive portions (13), said conductive bridges (16) comprising curved ends (18) arranged above and transversally to said first conductive portions (13) allowing to electrically connect said second conductive portions (15) to said first conductive portions (13); wherein said plurality of conductive bridges (16) are realised, in a number and arranged at a mutual distance in said conductive structure (14) such as to uniform the time constant of the plurality of elementary MOS transistors (2) in order to balance the dynamic response of said MOS device (1), the conductive bridges (16) being distributed so that each area of the gates structures (12) comprised between two consecutive ones of said conductive bridges (16) has the same highest gate resistance values (R_{polgate}) and a minimal gate resistance value linearly depending on the distance from the gate pad or gate finger.

2. MOS device according to claim 1, wherein said first conductive portions (13) are realised in polysilicon and they flank said central part (8) of the gate oxide (7).

3. MOS device according to claim 1, wherein said first conductive portions (13) are realised in a double layer made of polysilicon and of a metallic silicide.

4. MOS device according to claim 1, wherein said conductive bridges (16) are arranged transversally between two consecutive of said second conductive portions (15) and they comprise a flat portion (17) overlapped onto said semiconductor layer (4) and said curved ends (18).

5. MOS device according to claim 4, wherein between each of said flat portions (17) of said conductive bridges (16) and said
semiconductor layer (4) there is an insulating interconnection portion (19) suitable to avoid an electric contact between each of said flat portions (17) and said semiconductive layer (4)

6. MOS device according to claim 5, wherein said insulating interconnection portions (19) are realised by means of an oxide layer.

7. MOS device according to claim 6, wherein said insulating interconnection portions (19) transversally connect respective lateral portions (9) of said gate oxide (7) to each other.

8. MOS, device according to one or more of the preceding claims, wherein said second conductive portions (15) and said conductive bridges (16) are realised in polysilicon.

9. MOS device according to one or more of the preceding claims, wherein said second conductive portions (15) and/or said conductive bridges (16) are doped.

10. MOS device according to claim 1, wherein said second conductive portions (15) are realised in a double layer made of polysilicon and of a metallic silicide.

11. MOS device according to claim 1, wherein said second conductive portions (15) are realised in a metallic silicide layer.

12. MOS device according to claim 1, wherein said second conductive portions (15) are realised in a metallic layer.

13. MOS device according to one or more of the preceding claims, wherein said elementary MOS transistors (2) have body regions (10) and a source area (11) contained on top, said body regions (10) being realised between two consecutive of said conductive bridges (16), being insulated from each other and having a peripheral diffusion below said lateral portions (9) of said gate oxides (7) and below said consecutive conductive bridges (16) to define channel regions (21).

14. Method for realising a power MOS device of the type comprising a plurality of elementary power MOS transistors (2) comprising the steps of:
- making a thick oxide layer grow from a semiconductor layer (4) of a silicon plate;
- providing a photo-masking, by placing a resist, on said thick oxide layer to define a plurality of gate oxide parts;
- anisotropically etching the thick oxide layer and realising a plurality of thick gate oxide parts (8) ;
- removing the masking;
- realising a thinner gate oxide layer with respect to said thick oxide layer to form gate oxide portions (9) lateral to said thick gate oxide parts (8);
the obtained gate oxide (7) having thereby a thick central part (8) in direct contact with lateral portions (9) with reduced thickness for each elementary power MOS transistor,
said method comprising the steps of:
- depositing on top of said gate oxide (7) a conductive layer (40);
- providing a photo-masking of the conductive layer, by placing a resist (41), to define a gate structure (12) comprising a conductive structure (14) of the type comprising a plurality of second conductive portions (15) overlapped onto said thick central parts (8) of said gate oxide (7) and
- anisotropically etching, with formation of residue, said conductive layer (40) to define a plurality of first conductive portions (13) overlapped onto said lateral portions (9), said first conductive portions (13) defining for each of said elementary MOS transistors (2) a gate electrode;
- removing the resist (41);
said gate structure (12) comprising said plurality of first conductive portions (13) overlapped onto said lateral portions (9) of said gate oxide (7) and said conductive structure (14) connected to a gate pad or a gate finger of said device in order to distribute a signal coming from said gate pad or gate finger, said conductive structure (14) comprising
said plurality of second conductive portions (15) overlapped onto said thick central parts (8) of said gate oxide (7),
said anisotropically etching step of the conductive layer (40) defining also a plurality of conductive bridges (16) of said conductive structure (14) that interconnect to each othersaid second conductive portions (15) and said second conductive portions (15) to said first conductive portions (13);
said plurality of conductive bridges (16) comprising curved ends (18) arranged above and transversally to said first conductive portions (13) allowing to electrically connect said second conductive portions (15) to said first conductive portions (13), wherein said plurality of conductive bridges (16) are realised in a number and arranged at a mutual distance in said conductive structure (14) such as to uniform the time constant of the plurality of elementary MOS transistors (2) in order to balance the dynamic response of said MOS device (1), the conductive bridges (16) being distributed so that each area of the gate structures (12) comprised between two consecutive ones of said conductive bridges (16) has the same highest gate resistance value (R_{polgate}) and a minimal gate resistance value linearly depending on the distance from the gate pad or gate finger.

15. Method according to claim 14, wherein said conductive bridges (16) overlap onto a plurality of insulating interconnection portions (19), said interconnection portions (19) transversally connecting respective lateral portions (9) of said gate oxide (7) to each other.

16. Method according to claim 15, wherein said interconnection portions (19) are realised during said anisotropically etching step of the thick oxide layer.

17. Method according to one of previous claims 14 to 16, wherein it further comprises the steps of:
- forming a plurality of body wells to realise body regions (10) and source wells to realise source aeras (11) of said elementary MOS transistors (2), said body regions (10) being arranged between two consecutive of said conductive bridges (16) ,
being insulating from each other and having a peripheral diffusion below said lateral portions (9) of said gate oxides (7) and below said consecutive conductive bridges (16) to define channel regions (21).
and wherein it comprises the steps of:
- depositing an insulating layer (45) of suitable thickness;
- providing a photo-masking of said insulating layer (45) to define suitable silicidising areas in particular at the upper part of said second conductive portions (15) being made of silicon;
- depositing a suitable metallic layer (46);
- carrying out a thermal process or other process suitable to make said metallic layer (46) react with the uncovered silicon so as to form a silicide layer (50);
- etching and eliminating a portion of said non reacted metallic layer (46);
- covering said silicon plate with an intermediate dielectric layer (47) and forming metallisations (48) on the front and on the rest of said plate.

## Patentansprüche

1. Leistungs-MOS-Vorrichtung des Typs, die eine Mehrzahl elementarer MOS-Leistungstransistoren (2) mit jeweiligen Gatestrukturen (12) auf einer Halbleiterschicht (4) aufweist, wobei jede Gatestruktur ein Gateoxid (7) mit einem dicken zentralen Teil (8) in direktem Kontakt mit lateralen Bereichen (9) reduzierter Dicke aufweist,
wobei die Gatestrukturen (12) Folgendes aufweisen:
- erste leitfähige Bereiche (13), die die lateralen Bereiche (9) des Gateoxids (7) überlappend angeordnet sind, wobei die ersten leitfähigen Bereiche (13) für jeden der elementaren MOS-Transistoren (2) eine Gateelektrode bilden,
- eine leitfähige Struktur (14), die mit einer Gateanschlussfläche oder einem Gatefinger der MOS-Vorrichtung (1) verbunden ist, um ein von der Gateanschlussfläche oder dem Gatefinger kommendes Signal zu verteilen, wobei die leitfähige Struktur (14) eine Mehrzahl von zweiten leitfähigen Bereiche (15) aufweist, die den dicken zentralen Teil (8) des Gateoxids (7) jedes elementaren MOS-Transistors (2) überlappend angeordnet sind;
wobei die leitfähige Struktur (14) weiterhin eine Mehrzahl von leitfähigen Brücken (16) aufweist, die die zweiten leitfähigen Bereiche (15) miteinander verbinden und die zweiten leitfähigen Bereiche (15) mit den ersten leitfähigen Bereichen (13) verbinden, wobei die leitfähigen Brücken (16) gekrümmte Enden (18) aufweisen, die über und transversal zu den ersten leitfähigen Bereichen (13) angeordnet sind und eine elektrische Verbindung der zweiten leitfähigen Bereiche (15) mit den ersten leitfähigen Bereichen (13) ermöglichen;
wobei die Mehrzahl von leitfähigen Brücken (16) in einer Anzahl realisiert und in einem gegenseitigen Abstand in der leitfähigen Struktur (14) angeordnet sind, so dass die Zeitkonstante der Mehrzahl von elementaren MOS-Transistoren (2) einheitlich ist und dadurch das dynamische Ansprechen der MOS-Vorrichtung (1) ausgeglichen ist,
wobei die leitfähigen Brücken (16) derart verteilt sind, dass jeder Bereich der Gatestrukturen (16), der zwischen zwei aufeinander folgenden Brücken (16) vorhanden ist, den gleichen höchsten Gatewiderstandswert (R_{polgate}) und einen minimalen Gatewiderstandswert in linearer Abhängigkeit von dem Abstand von der Gateanschlussfläche oder dem Gatefinger aufweist.

2. MOS-Vorrichtung nach Anspruch 1,
wobei die ersten leitfähigen Bereiche (13) in Polysilizium realisiert sind und den zentralen Teil (8) des Gateoxids (7) flankieren.

3. MOS-Vorrichtung nach Anspruch 1,
wobei die ersten leitfähigen Bereiche (13) in einer Doppelschicht realisiert sind, die aus Polysilizium und aus einem Metallsilizid gebildet ist.

4. MOS-Vorrichtung nach Anspruch 1,
wobei die leitfähigen Brücken (16) transversal zwischen zwei aufeinander folgenden der zweiten leitfähigen Bereich (15) angeordnet sind und einen flachen Bereich (17) aufweisen, der die Halbleiterschicht (4) und die gekrümmten Enden (18) überlappend angeordnet ist.

5. MOS-Vorrichtung nach Anspruch 4,
wobei zwischen den flachen Bereichen (17) der leitfähigen Brücken (16) und der Halbleiterschicht (4) jeweils ein isolierender Zwischenverbindungsbereich (19) vorhanden ist, der dafür geeignet ist, einen elektrischen Kontakt zwischen den jeweiligen flachen Bereichen (17) und der Halbleiterschicht (4) zu vermeiden.

6. MOS-Vorrichtung nach Anspruch 5,
wobei die isolierenden Zwischenverbindungsbereiche (19) mittels einer Oxidschicht realisiert sind.

7. MOS-Vorrichtung nach Anspruch 6,
wobei die isolierenden Zwischenverbindungsbereiche (19) die jeweiligen lateralen Bereiche (9) des Gateoxids (7) transversal miteinander verbinden.

8. MOS-Vorrichtung nach einem oder mehreren der vorausgehenden Ansprüche,
wobei die zweiten leitfähigen Bereiche (15) und die leitfähigen Brücken (16) in Polysilizium realisiert sind.

9. MOS-Vorrichtung nach einem oder mehreren der vorausgehenden Ansprüche,
wobei die zweiten leitfähigen Bereiche (15) und/oder die leitfähigen Brücken (16) dotiert sind.

10. MOS-Vorrichtung nach Anspruch 1,
wobei die zweiten leitfähigen Bereiche (15) in einer Doppelschicht realisiert sind, die aus Polysilizium und aus einem Metallsilizid gebildet ist.

11. MOS-Vorrichtung nach Anspruch 1,
wobei die zweiten leitfähigen Bereiche (15) in einer Metallsilizidschicht realisiert sind.

12. MOS-Vorrichtung nach Anspruch 1,
wobei die zweiten leitfähigen Bereiche (15) in einer metallischen Schicht realisiert sind.

13. MOS-Vorrichtung nach einem oder mehreren der vorausgehenden Ansprüche,
wobei die elementaren MOS-Transistoren (2) Körperbereiche (10) und einen oben enthaltenen Sourcebereich (11) aufweisen, wobei die Körperbereiche (10) zwischen zwei aufeinander folgenden der leitfähigen Brücken (16) realisiert sind, voneinander isoliert sind und eine periphere Diffusion unter den lateralen Bereichen (9) der Gateoxide (7) sowie unter den aufeinander folgenden leitfähigen Brücken (16) aufweisen, um Kanalbereiche (21) zu bilden.

14. Verfahren zum Realisieren einer Leistungs-MOS-Vorrichtung des Typs mit einer Mehrzahl von elementaren MOS-Leistungstransistoren (2), wobei das Verfahren folgende Schritte aufweist:
- Wachsen-Lassen einer dicken Oxidschicht aus einer Halbleiterschicht (4) einer Siliziumplatte;
- Vorsehen einer Fotomaske durch Platzieren eines Resist auf der dicken Oxidschicht, um eine Mehrzahl von Gateoxidteilen zu bilden;
- anisotropes Ätzen der dicken Oxidschicht und Realisieren einer Mehrzahl von dicken Gateoxidteilen (8);
- Entfernen der Maske;
- Realisieren einer dünneren Gateoxidschicht in Bezug auf die dicke Oxidschicht, um Gateoxidbereiche (9) seitlich von den dicken Gateoxidteilen (8) zu bilden;
wobei das gebildete Gateoxid (7) dadurch einen dicken zentralen Teil (8) in direktem Kontakt mit lateralen Bereichen (9) mit reduzierter Dicke für jeden elementaren MOS-Leistungstransistor aufweist,
wobei das Verfahren ferner Folgende Schritte aufweist:
- Aufbringen einer leitfähigen Schicht (40) oben auf dem Gateoxid (7);
- Vorsehen einer Fotomaske an der leitfähigen Schicht durch Platzieren eines Resist (41), um eine Gatestruktur (12) zu bilden, die eine leitfähige Struktur (14) des Typs mit einer Mehrzahl von zweiten leitfähigen Bereichen (15) aufweist, die die dicken zentralen Teile (8) des Gateoxids (7) überlappend angeordnet sind, und
- anisotropes Ätzen der leitfähigen Schicht (20) unter Bildung von Rückständen, um eine Mehrzahl von ersten leitfähigen Bereichen (13) zu bilden, die die lateralen Bereiche (9) überlappend angeordnet sind, wobei die ersten leitfähigen Bereiche (13) für jeden der elementaren MOS-Transistoren (2) eine Gateelektrode bilden;
- Entfernen des Resist (41);
wobei die Gatestruktur (12) die Mehrzahl der ersten leitfähigen Bereiche (13) aufweist, die die lateralen Bereiche (9) der Gatestruktur (7) überlappend angeordnet sind, und die leitfähige Struktur (14) mit einer Gateanschlussfläche oder einem Gatefinger der Vorrichtung verbunden wird, um ein von der Gateanschlussfläche oder dem Gatefinger kommendes Signal zu verteilen, wobei die leitfähige Struktur (14) die Mehrzahl der zweiten leitfähigen Bereiche (15) aufweist, die die dicken zentralen Teile (8) des Gateoxids (7) überlappend angeordnet sind,
wobei der Schritt des anisotropen Ätzens der leitfähigen Schicht (40) auch eine Mehrzahl von leitfähigen Brücken (16) der leitfähigen Struktur (14) bildet, die die zweiten leitfähigen Bereiche (15) miteinander verbinden und die zweiten leitfähigen Bereiche (15) mit den ersten leitfähigen Bereichen (13) verbinden;
wobei die Mehrzahl der leitfähigen Brücken (16) gekrümmte Enden (18) aufweisen, die über und transversal zu den ersten leitfähigen Bereichen (13) angeordnet sind und eine elektrische Verbindung der zweiten leitfähigen Bereiche (15) mit den ersten leitfähigen Bereichen (13) ermöglichen, wobei die Mehrzahl der leitfähigen Brücken (16) in einer Anzahl realisiert und in einem gegenseitigen Abstand in der leitfähigen Struktur (14) angeordnet sind, so dass die Zeitkonstante der Mehrzahl von elementaren MOS-Transistoren (2) einheitlich ist und dadurch das dynamische Ansprechen der MOS-Vorrichtung (1) ausgeglichen ist,
wobei die leitfähigen Brücken (16) derart verteilt sind, dass jeder Bereich der Gatestrukturen (16), der zwischen zwei aufeinander folgenden Brücken (16) vorhanden ist, den gleichen höchsten Gatewiderstandswert (R_{polgate}) und einen minimalen Gatewiderstandswert in linearer Abhängigkeit von dem Abstand von der Gateanschlussfläche oder dem Gatefinger aufweist.

15. Verfahren nach Anspruch 14,
wobei die leitfähigen Brücken (16) in einer Mehrzahl von isolierenden Zwischenverbindungsbereichen (19) überlappend vorgesehen werden, wobei die Zwischenverbindungsbereiche (19) jeweilige laterale Bereiche (9) des Gateoxids (7) transversal miteinander verbinden.

16. Verfahren nach Anspruch 15,
wobei die Zwischenverbindungsbereiche (19) während des anisotropen Ätzschrittes der dicken Oxidschicht realisiert werden.

17. Verfahren nach einem der Ansprüche 14 bis 16,
wobei das Verfahren ferner folgende Schritte aufweist:
- Bilden einer Mehrzahl von Körper-Wannen zum Realisieren von Körperbereichen (10) und Source-Wannen zum Realisieren von Source-Bereichen (11) der elementaren MOS-Transistoren (2), wobei die Körperbereiche (10) zwischen zwei aufeinander folgenden der leitfähigen Brücken (16) angeordnet werden, voneinander isoliert sind und eine periphere Diffusion unter den lateralen Bereichen (9) der Gateoxide (7) und unter den aufeinander folgenden leitfähigen Brücken (16) aufweisen, um Kanalbereiche (21) zu bilden, und wobei das Verfahren ferner folgende Schritte aufweist:
- Aufbringen einer Isolierschicht (45) geeigneter Dicke;
- Vorsehen einer Fotomaske an der Isolierschicht, um geeignete Silizidierungsbereiche insbesondere an dem oberen Teil der aus Silizium gebildeten, zweiten leitfähigen Bereiche (15) zu bilden;
- Aufbringen einer geeigneten metallischen Schicht (46);
- Ausführen eines thermischen Prozesses oder eines anderen Prozesses, der geeignet ist, die metallische Schicht (46) mit dem unbedeckten Silizium reagieren zu lassen, um dadurch eine Silizidschicht (50) zu bilden;
- Ätzen und Eliminieren eines Bereichs der unreagierten metallischen Schicht (46);
- Bedecken der Siliziumplatte mit einer zwischengeordneten dielektrischen Schicht (47) und Bilden von Metallisierungen (48) an der Vorderseite sowie am Rest der Platte.

## Revendications

1. Dispositif MOS de puissance du type comprenant une pluralité de transistors MOS de puissance élémentaires (2) présentant des structures de grille (12) respectives sur une couche de semi-conducteur (4), chaque structure de grille comprenant un oxyde de grille (7) présentant une partie centrale épaisse (8) en contact direct avec des portions latérales (9) d'épaisseur réduite,
les structures de grille (12) comprenant :
- des premières portions conductrices (13) qui chevauchent les portions latérales (9) de l'oxyde de grille (7), les premières portions conductrices (13) définissant pour chacun des transistors MOS élémentaires (2) une électrode de grille,
- une structure conductrice (14) connectée à une plage de grille ou à un doigt de grille d'un dispositif MOS (1) afin de répartir un signal en provenance de la plage de grille ou du doigt de grille, la structure conductrice (14) comprenant une pluralité de secondes portions conductrices (15) qui chevauchent la partie centrale épaisse (8) de l'oxyde de grille (7) de chaque transistor MOS élémentaire (2),
la structure conductrice (14) comprenant en outre une pluralité de ponts conducteurs (16) qui interconnectent les secondes portions conductrices (15) entre elles et les secondes portions conductrices (15) aux premières portions conductrices (13), les ponts conducteurs (16) comprenant des extrémités courbées (18) disposées au-dessus des premières portions conductrices (13) de façon transversale permettant de connecter électriquement les secondes portions conductrices (15) aux premières portions conductrices (13) ;
dans lequel la pluralité de ponts conducteurs (16) sont réalisés en nombre et disposés à une distance mutuelle dans la structure conductrice (14) de façon à uniformiser la constante de temps de la pluralité de transistors MOS élémentaires (2) afin d'équilibrer la réponse dynamique du dispositif MOS (1), les ponts conducteurs (16) étant répartis de telle sorte que chaque zone des structures de grille (12) comprise entre deux zones consécutives des ponts conducteurs (16) présente la même valeur maximale de résistance de grille (R_{polgate}) et une valeur minimale de résistance de grille dépendant linéairement de la distance depuis la plage de grille ou le doigt de grille.

2. Dispositif MOS selon la revendication 1, dans lequel les premières portions conductrices (13) sont réalisées en polysilicone et encadrent la partie centrale (8) de l'oxyde de grille (7).

3. Dispositif MOS selon la revendication 1, dans lequel les premières portions conductrices (13) sont réalisées en une double couche faite de polysilicone et d'un siliciure métallique.

4. Dispositif MOS selon la revendication 1, dans lequel les ponts conducteurs (16) sont disposés de façon transversale entre deux portions consécutives des secondes portions conductrices (15) et comprennent une portion plate (17) chevauchant la couche de semi-conducteur (4) et les extrémités courbées (18).

5. Dispositif MOS selon la revendication 4, dans lequel, entre chacune des portions plates (17) des ponts conducteurs (16) et la couche de semi-conducteur (4), il y a une portion isolante d'interconnexion (19) adaptée pour éviter un contact électrique entre chacune des portions plates (17) et la couche de semi-conducteur (4).

6. Dispositif MOS selon la revendication 5, dans lequel les portions isolantes d'interconnexion (19) sont réalisées au moyen d'une couche d'oxyde.

7. Dispositif MOS selon la revendication 6, dans lequel les portions isolantes d'interconnexion (19) connectent de façon transversale des portions latérales (9) respectives de l'oxyde de grille (7) les unes aux autres.

8. Dispositif MOS selon une ou plusieurs des revendications précédentes, dans lequel les secondes portions conductrices (15) et les ponts conducteurs (16) sont réalisés en polysilicone.

9. Dispositif MOS selon une ou plusieurs des revendications précédentes, dans lequel les secondes portions conductrices (15) et/ou les ponts conducteurs (16) sont dopés.

10. Dispositif MOS selon la revendication 1, dans lequel les secondes portions conductrices (15) sont réalisées en une double couche faite de polysilicone et d'un siliciure métallique.

11. Dispositif MOS selon la revendication 1, dans lequel les secondes portions conductrices (15) sont réalisées en une couche de siliciure métallique.

12. Dispositif MOS selon la revendication 1, dans lequel les secondes portions conductrices (15) sont réalisées en une couche métallique.

13. Dispositif MOS selon une ou plusieurs des revendications précédentes, dans lequel les transistors MOS élémentaires (2) présentent des régions de corps (10) et une zone de source (11) contenue sur le dessus, les régions de corps (10) étant réalisées entre deux ponts consécutifs des ponts conducteurs (16), étant isolées les unes des autres et présentant une diffusion périphérique en-dessous des portions latérales (9) des oxydes de grille (7) et en-dessous des ponts conducteurs (16) consécutifs afin de définir des régions de canal (21).

14. Procédé de réalisation d'un dispositif MOS de puissance du type comprenant une pluralité de transistors MOS de puissance élémentaires (2) comprenant les étapes consistant à :
- faire croître une épaisse couche d'oxyde à partir d'une couche de semi-conducteur (4) d'une plaque de silicium,
- prévoir un masquage photo, en plaçant une réserve, sur la couche épaisse d'oxyde afin de définir une pluralité de parties d'oxydes de grille,
- effectuer une gravure anisotrope de la couche épaisse d'oxyde et réaliser une pluralité de parties épaisses d'oxyde de grille (8),
- retirer le masquage,
- réaliser une couche d'oxyde de grille plus fine par rapport à la couche d'oxyde épaisse afin de former des portions d'oxyde de grille (9) latérales par rapport aux parties épaisses d'oxyde de grille (8),
l'oxyde de grille (7) obtenu présentant ainsi une partie centrale épaisse (8) en contact direct avec des portions latérales (9) d'une épaisseur réduite pour chaque transistor MOS de puissance élémentaire,
le procédé comprenant les étapes consistant à :
- déposer sur le dessus de l'oxyde de grille (7) une couche conductrice (40),
- prévoir un masquage photo de la couche conductrice, en plaçant une réserve (41), afin de définir une structure de grille (12) comprenant une structure conductrice (14) du type comprenant une pluralité de secondes portions conductrices (15) qui chevauchent les parties centrales épaisses (8) de l'oxyde de grille (7), et
- effectuer une gravure anisotrope, avec formation de résidus, de la couche conductrice (40) afin de définir une pluralité de premières portions conductrices (13) qui chevauchent les portions latérales (9), les premières portions conductrices (13) définissant pour chacun des transistors MOS élémentaires (2) une électrode de grille,
- retirer la réserve (41),
la structure de grille (12) comprenant la pluralité des premières portions conductrices (13) qui chevauchent les portions latérales (9) de l'oxyde de grille (7) et la structure conductrice (14) connectée à une plage de grille ou un doigt de grille du dispositif afin de répartir un signal en provenance de la plage de grille ou du doigt de grille, la structure conductrice (14) comprenant la pluralité de secondes portions conductrices (15) qui chevauchent les parties centrales épaisses (8) de l'oxyde de grille (7),
l'étape de gravure anisotrope de la couche conductrice (40) définissant également une pluralité de ponts conducteurs (16) de la structure conductrice (14) qui interconnectent les secondes portions conductrices (15) les unes avec les autres et les secondes portions conductrices (15) avec les premières portions conductrices (13),
la pluralité de ponts conducteurs (16) comprenant des extrémités courbées (18) agencées au-dessus des premières portions conductrices (13) de façon transversale permettant de connecter électriquement les secondes portions conductrices (15) aux premières portions conductrices (13), dans lequel la pluralité de ponts conducteurs (16) sont réalisés en nombre et disposés à une distance mutuelle dans la structure conductrice (14) de manière à uniformiser la constante de temps de la pluralité de transistors MOS élémentaires (2) afin d'équilibrer la réponse dynamique du dispositif MOS (1), les ponts conducteurs (16) étant repartis de telle sorte que chaque zone des structures de grille (12) comprise entre deux zones consécutives des ponts conducteurs (16) présente la même valeur maximale de résistance de grille (R_{polgate}) et une valeur minimale de résistance de grille dépendant linéairement de la distance depuis la plage de grille ou le doigt de grille.

15. Procédé selon la revendication 14, dans lequel les ponts conducteurs (16) se chevauchent en une pluralité de portions isolantes d'interconnexion (19), les portions d'interconnexion (19) connectant de façon transversale les portions latérales (9) respectives de l'oxyde de grille (7) les unes aux autres.

16. Procédé selon la revendication 15, dans lequel les portions d'interconnexion (19) sont réalisées lors de l'étape de gravure anisotrope de la couche épaisse d'oxyde.

17. Procédé selon l'une des revendications 14 à 16, dans lequel il comprend en outre les étapes consistant à :
former une pluralité de puits de corps afin de réaliser des régions de corps (10) et des puits de source afin de réaliser des zones de source (11) des transistors MOS élémentaires (2), les régions de corps (10) étant agencées entre deux ponts consécutifs des ponts conducteurs (16), étant isolées les unes des autres et
présentant une diffusion périphérique en-dessous des portions latérales (9) des oxydes de grille (7) et en-dessous des ponts conducteurs (16) consécutifs afin de définir des régions de canal (21)
et dans lequel il comprend les étapes consistant à :
- déposer une couche d'isolation (45) d'épaisseur adaptée,
- prévoir un masquage photo de la couche d'isolation (45) afin de définir des zones de siliciuration adaptées en particulier sur la partie supérieure des secondes portions conductrices (15) étant faites en silicium,
- déposer une couche métallique adaptée (46),
- procéder à un traitement thermique ou un autre traitement adapté afin de faire réagir la couche métallique (46) avec le silicium découvert pour former une couche de siliciure (50),
- graver et éliminer une portion de la couche métallique n'ayant pas réagi (46),
- recouvrir la plaque de silicium avec une couche de diélectrique intermédiaire (47) et former des métallisations (48) sur le devant et le reste de la plaque.
